(19)

**Europäisches Patentamt**
**European Patent Office**
**Office européen des brevets**

(11)  **EP 4 105 071 B1**

(12)  **EUROPEAN PATENT SPECIFICATION**

(45) Date of publication and mention
of the grant of the patent:
**04.06.2025 Bulletin 2025/23**

(21) Application number: **21752987.4**

(22) Date of filing: **14.01.2021**

(51) International Patent Classification (IPC):
**B60N 2/02** *(2006.01)*   **H03K 17/96** *(2006.01)*
**B60N 2/60** *(2006.01)*

(52) Cooperative Patent Classification (CPC):
**H03K 17/962; B60N 2/0228; B60N 2/6009;**
B60N 2/0239; B60N 2210/12; H03K 2017/9602;
H03K 2217/96062; H03K 2217/960755;
H03K 2217/960765

(86) International application number:
**PCT/CN2021/071652**

(87) International publication number:
**WO 2021/159910 (19.08.2021 Gazette 2021/33)**

(54) **AUTOMOBILE SEAT ADJUSTMENT SWITCH BASED ON 3D TOUCH CONTROL**

AUF 3D-BERÜHRUNGSSTEUERUNG BASIERENDER FAHRZEUGSITZVERSTELLSCHALTER

COMMUTATEUR DE RÉGLAGE DE SIÈGE D'AUTOMOBILE BASÉ SUR UNE COMMANDE
TACTILE 3D

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **14.02.2020 CN 202020169371 U**

(43) Date of publication of application:
**21.12.2022 Bulletin 2022/51**

(73) Proprietor: **Yanfeng Adient Seating Co. Ltd.
Kangqiao Industrial Zone,
Pudong New Area
Shanghai 201315 (CN)**

(72) Inventors:
 • **HUANG, Hao**
   **Shanghai 201315 (CN)**
 • **MAO, Jun**
   **Shanghai 201315 (CN)**
 • **TAO, Huijia**
   **Shanghai 201315 (CN)**

 • **ZHANG, Chen**
   **Shanghai 201315 (CN)**
 • **LI, Fangqin**
   **Shanghai 201315 (CN)**
 • **GU, Shengfeng**
   **Shanghai 201315 (CN)**
 • **XU, Zhicheng**
   **Shanghai 201315 (CN)**

(74) Representative: **dompatent von Kreisler Selting
Werner -
Partnerschaft von Patent- und Rechtsanwälten
mbB
Deichmannhaus am Dom
Bahnhofsvorplatz 1
50667 Köln (DE)**

(56) References cited:
  WO-A1-2013/058708   CN-A- 101 102 917
  CN-A- 101 102 917   CN-A- 109 039 318
  CN-A- 109 039 318   CN-U- 208 053 171
  CN-U- 211 617 491   US-A1- 2013 263 252

**Description**

**TECHNICAL FIELD**

The present invention relates to an automobile seat control switch, and in particular, to a 3D touch control-based automobile seat adjustment switch.

**BACKGROUND**

With the development of automobile intellectualization, an automobile seat has increasingly more functions, and increasingly more corresponding function control switches are provided. At present, most of the control switches of the automobile seat are physical switches. The physical switch in the prior art has a relatively large size. An arrangement mode of the plurality of physical switches on the seat and circuit structures of the physical switches are complex, which require a larger arrangement space. Assembling is complicated and the mass is large, and an expanded hole may be caused after the physical switch is operated, which may lead to a risk of abnormal sticking. In addition, since the seat control switch is generally arranged on a side of a side shield, less space is reserved for operation by hand, which affects adjustment comfort.

In order to resolve the problem of sticking of the physical switch, touch control switch is mounted to seats of some vehicles. However, since the seat control switch is generally arranged on the side of the side shield, the side is a non-visual region and is required to be operated blindly. Most of the touch switches in the prior art have a planar structure and should be operated under a visible condition, which brings great inconvenience to the adjustment and control of the seat.

WO 2013/058708 A1 discloses a method, comprising: patterning one or more electrical layers on a substrate; shaping the patterned substrate into a dimensional contour, wherein the contour including a significant change in gradient in or adjacent to one or more sensing areas of the electrical layer-, and over-molding the shaped substrate, wherein degradation of a trace in the electrical layer at or adjacent to the one or more sensing areas during shaping and/or over-molding is substantially minimized based on the width of the trace, the thickness or number of layers of the trace, the bending radius of the trace, the material of the trace, and/or a primer over layer on the trace.

CN 101102917 A discloses a seat control system for a vehicle. The system includes a substrate with a plurality of touch zones disposed on one surface of the substrate, and a plurality of electrode patterns disposed on the opposite surface. An inner electrode of each pattern is aligned with one of the touch zones. Each pattern is electrically coupled to an active electrical component, which energizes the electrodes of the pattern such that electric fields emanate therefrom. The pattern may be capacitively coupled to the component. When the electric field of the inner electrode is disturbed by a stimulus proximate the corresponding touch zone, the component is activated. Upon activation of one of the components, a controller causes the seat to move in a desired direction.

CN 109039318 A discloses the technical field of touch key vibration, and discloses a touch key vibration feedback touch control device, control circuit and control method thereof. The device includesa touch panel, panel support, PCB and rear lid, a plurality of touch keys are arranged on the touch panel, a vibration motor is fixedly installed on the touch panel, a flexible part is arranged between the touch panel and the panel bracket, the touch panel and the panel bracket are flexibly connected, the panel bracket and the PCB are fixedly installed on the rear cover, the touch panel, the vibration motor and the PCB are electrically connected, the touch panel and the panel bracket of the disclosure are flexibly connected, the vibration can be effectively transmitted to the control area of the touch panel without transmitting the vibration to other positions through the panel bracket, and the vibration of the control area of the touch panel can be reduced.

**SUMMARY**

The present invention is intended to provide a 3D touch control-based automobile seat adjustment switch. In this way, adjustment of an automobile seat can be controlled by using a 3D touch assembly, thereby satisfying requirements for a reasonable vehicle space arrangement and lightweight accessories.

The present invention is implemented as follows:
A 3D touch control-based automobile seat adjustment switch is provided, including an insulating cover plate, a touch sensor, a base, a feedback module, a circuit board, and a module assembly cover plate. A plurality of protruding or recessed touch control regions are arranged on the insulating cover plate. A plurality of independent touch sensors are seamlessly attached to the plurality of touch control regions on the insulating cover plate, to form a 3D touch assembly, and the plurality of touch sensors are all connected to the circuit board. The circuit board is assembled on the module assembly cover plate, the module assembly cover plate and the feedback module are assembled on one surface of the base, the feedback module is connected to the circuit board, and an other surface of the base is assembled on the insulating cover plate. The automobile seat adjustment switch is assembled on a side shield of an automobile seat.

The feedback module is a combination of more than one of a vibration motor, a pressure element, an electromagnet, or a buzzer.

The feedback module includes the vibration motor and the pressure element. The vibration motor is arranged between the circuit board and the base. The pressure element is a diaphragm pressure sensor and is attached between the circuit board and the module assembly cover plate.

The touch sensor includes a flexible substrate and a conductive wire, the conductive wire is printed on the flexible substrate, and the flexible substrate is seamlessly attached to surfaces of the touch control regions by using a double-sided tape.

The plurality of touch control regions are not in a same plane, and each touch control region forms an independent branch circuit with the circuit board through the touch sensor on the touch control region.

An area of the touch control region is not less than 5*5 mm.

An embedding opening is arranged on the side shield, so that the insulating cover plate is embedded in the embedding opening of the side shield in a matched manner, and the base is assembled on the side shield.

The insulating cover plate is directly mounted to the automobile seat as a non-hollowed-out side shield. The touch sensor, the base, the feedback module, the circuit board, and the module assembly cover plate are mounted to the non-hollowed-out side shield.

Compared with the prior art, the present invention has the following advantageous effects:

1. In the present invention, the 3D touch assembly is adopted, and a conventional physical switch is replaced by the touch switch, so that a volume is reduced by 30%, thereby realizing lightweight accessories such as the switch. In addition, molds such as a switch button is reduced, and manufacturing costs and the assembly difficulty are reduced, thereby avoiding a risk of switch sticking.

2. In the present invention, a protruding or recessed touch control region is adopted, which is convenient to identify a position of each function switch. Therefore, the requirement for blind operation is satisfied while increasing the space for operation by hand.

3. In the present invention, the independent touch sensors are adopted to respectively realize the adjustment functions of the automobile seat. A number, an arrangement position, and directions of the touch sensors may be adjusted or customized according to a model and a usage requirement, and the like. With a high modularity degree, the touch sensors may be arranged on surfaces of different shapes with high flexibility.

4. The present invention may be applicable to various switches of the automobile seat, a door and a window, an instrument panel, and the like, which has a wide range of applications and may be integrated with an accessory such as an ambient lamp to improve aesthetics and functionality of an automobile.

The present invention can control various adjustment modes of the automobile seat by using the 3D touch assembly, so that the vehicle space arrangement is more reasonable, blind operation of the seat touch switch can be realized, and the accessories such as the switch can meet the requirements for the light weight and low costs.

## BRIEF DESCRIPTION OF THE DRAWINGS

FIG. 1 is a schematic structural diagram of a 3D touch control-based automobile seat adjustment switch according to the present invention.

FIG. 2 is an exploded view of a 3D touch control-based automobile seat adjustment switch according to the present invention.

FIG. 3 is a bottom view of an insulating cover plate in a 3D touch control-based automobile seat adjustment switch according to the present invention.

FIG. 4 is an arrangement diagram of a touch control region in a 3D touch control-based automobile seat adjustment switch according to the present invention.

FIG. 5 is a front view of a seat back touch sensor in a 3D touch control-based automobile seat adjustment switch according to the present invention.

FIG. 6 is a bottom view of a seat back touch sensor in a 3D touch control-based automobile seat adjustment switch according to the present invention.

FIG. 7 is a front view of a lumbar support touch sensor in a 3D touch control-based automobile seat adjustment switch according to the present invention.

FIG. 8 is a bottom view of a lumbar support touch sensor in a 3D touch control-based automobile seat adjustment switch according to the present invention.

FIG. 9 is a schematic circuit diagram of a 3D touch control-based automobile seat adjustment switch according to the present invention.

FIG. 10 is a cross-sectional view of installation of one feedback module in a 3D touch control-based automobile seat adjustment switch.

FIG. 11 is a cross-sectional view of installation of a feedback module of a 3D touch control-based automobile seat adjustment switch according to the present invention.

FIG. 12 is an operating principle diagram of a conductive touch structure of a 3D touch control-based automobile seat adjustment switch according to the present invention.

In the figure, 1. Insulating cover plate; 11. Touch control region; 2. Touch sensor; 21. Seat back touch sensor; 22. Lumbar support touch sensor; 3. Base; 4. Feedback module; 41. Vibration motor; 42. Pressure element; 5. Circuit board; 6. Module assembly cover plate; 7. Side shield; 71. embedding opening; 8. Main control module.

**DETAILED DESCRIPTION**

The present invention will be further described below with reference to the accompanying drawings and specific embodiments.

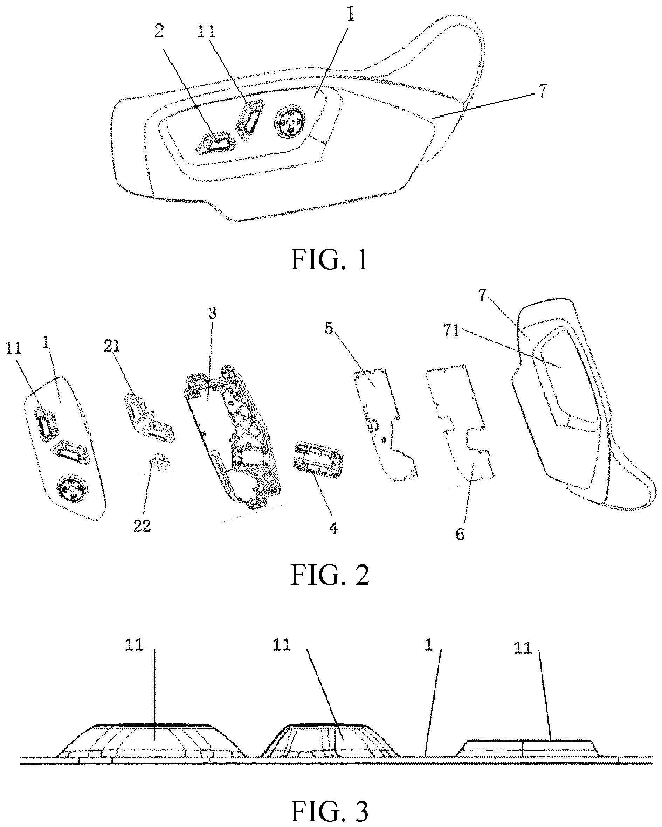

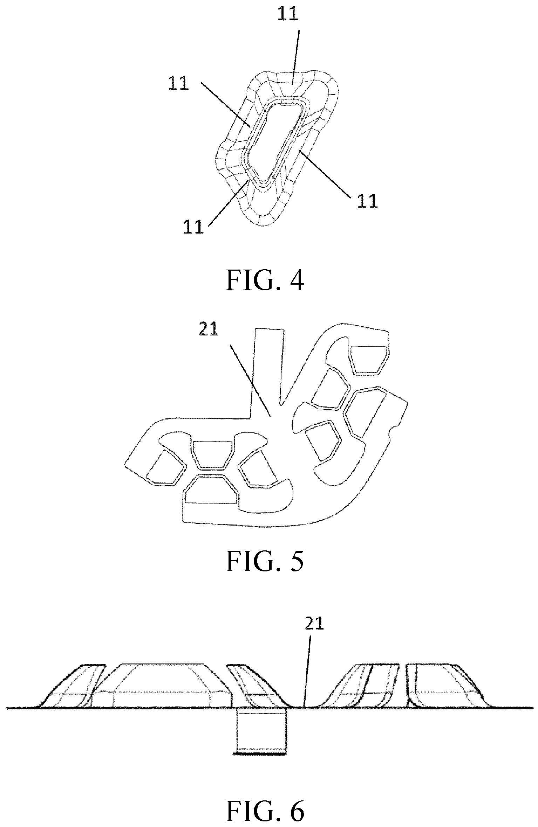

Referring to FIG. 1 and FIG. 2, a 3D touch control-based automobile seat adjustment switch is provided. The automobile seat adjustment switch includes an insulating cover plate 1, a touch sensor 2, a base 3, a feedback module 4, a circuit board 5, and a module assembly cover plate 6. Referring to FIG. 3 and FIG. 4, a plurality of protruding or recessed touch control regions 11 are arranged on the insulating cover plate 1. Different control functions may be distinguished by touching, so as to achieve blind operation. A plurality of independent touch sensors 2 are seamlessly attached to the plurality of touch control regions 11 on the insulating cover plate 1, to ensure sensitivity and reliability of the touch control and form a 3D touch assembly. In addition, the plurality of touch sensors 2 are all connected to the circuit board 5 by wires, so as to transmit a touch signal source. The circuit board 5 is assembled on the module assembly cover plate 6 by screws. The module assembly cover plate 6 and the feedback module 4 are assembled on one surface of the base 3 by screws, the feedback module 4 is connected to the circuit board 5 by a wire, and an other surface of the base 3 is assembled on the insulating cover plate 1 by screws. The base 3 of the automobile seat adjustment switch is assembled on a side shield 7 of an automobile seat by screws, which is quick and easy to assemble and disassemble and realizes aesthetics. The occupied space is greatly reduced, and an assembling requirement for a light weight is also achieved.

The feedback module 4 is a combination of more than one of feedback elements such as a vibration motor, a pressure element, an electromagnet, or a buzzer. An appropriate feedback module 4 may be selected according to requirements for functionality and vehicle models.

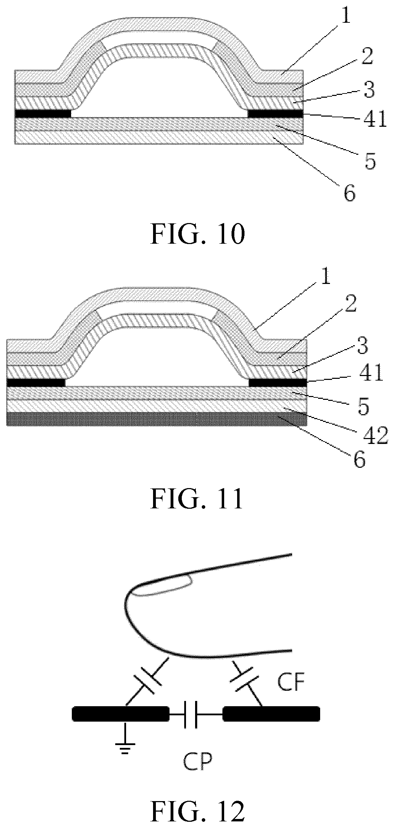

Referring to FIG. 10, when the feedback module 4 is a vibration motor 41, the vibration motor 41 is arranged between the circuit board 5 and the base 3. When the touch sensor 2 transmits the touch signal source to the circuit board 5, the circuit board 5 converts the touch signal source and outputs power to the vibration motor 41 to confirm contact between a finger and the touch sensor 2, thereby realizing touch feedback, which indicates that an adjustment function of the seat starts to be enabled, and the power is ON. Therefore, the circuit board 5 outputs a bus signal to a main control module 8 of the automobile seat to drive the main control module 8.

Referring to FIG. 11, according to the present invention, the feedback module 4 is the vibration motor 41 and a pressure element 42, the vibration motor 41 is arranged between the circuit board 5 and the base 3. The pressure element 42 is a diaphragm pressure sensor and attached between the circuit board 5 and the module assembly cover plate 6. When the touch sensor 2 transmits the touch signal source to the circuit board 5, the circuit board 5 converts the touch signal source and outputs power to the vibration motor 41, to confirm the contact between the finger and the touch sensor 2, thereby realizing first-level touch feedback. The finger continues to press the touch sensor 2, the pressure element 42 deforms and sends a signal to the circuit board 5, and the circuit board 5 drives the vibration motor 41 to realize second-level touch feedback, which indicates that an adjustment function of the seat starts to be enabled, and the power is ON. Therefore, the circuit board 5 outputs the bus signal to the main control module 8 of the automobile seat to drive the main control module 8. The diaphragm pressure sensor, a capacitive pressure sensor, an infrared pressure sensor, and the like may be configured as the pressure element 42 to detect slight deformation of the insulating cover plate 1.

Referring to FIG. 5 to FIG. 8, the touch sensor 2 includes a flexible substrate and a conductive wire. The conductive wire is printed on the flexible substrate by a screen printing process, and the flexible substrate is seamlessly attached to a surface of the touch control region 11 by using a double-sided tape, so that a conductive touch structure is formed between the touch sensor 2 and the finger. Generally, the touch sensor 2 may be manufactured into a seat back touch sensor 21 and a lumbar support touch sensor 22, to respectively satisfy requirements for seat back control and lumbar support control of the automobile seat.

Preferably, the flexible substrate may be made of polyethylene terephthalate (PET) or polycarbonate (PC). The conductive wire may be made of a copper foil, PEDOT (PEDOT is a polymer of 3,4-ethylenedioxythiophene monomers), a metal grid, a nano silver wire, and the like. The conductive wire is printed on the flexible substrate by the screen printing process to form a touch layer with certain flexibility. The flexible substrate may be seamlessly pasted on the touch control region 11 by using an adhesive such as a non-substrate double-sided tape, to ensure reliability of touch sensing of each touch sensor 2.

Preferably, depending on different types of touch sensors 2, touch sensing methods of the touch sensors 2 may be sliding, pressing, and the like. Touch signal sources of the touch sensor 2 may include a touch time, a number of touches, coordinates of a touch point, a movement speed of the touch point, a movement distance of the touch point, and the like.

The plurality of touch control regions 11 are not in a same plane, and each touch control region 11 forms an independent branch circuit with the circuit board 5 through the touch sensor 2 on the touch control region 11. Each touch control region 11 may be identified by the recessed or protruding structure and the distribution position, which is convenient for the blind operation to control different adjustment modes of the automobile seat. The plurality of touch control regions 11 may include a slideway backward region, a slideway forward region, a front down region, a front up region, a back down region, a back up region, a backrest backward region, a backrest forward region, a lumbar support forward region, a lumbar support backward region, a lumbar support upward region, and a lumbar support downward region, so as to respectively meet various adjustment requirements for the seat back and the lumbar support of the current vehicle seat.

An area of the touch control region 11 is not less than 5*5 mm, and a size of the touch control region 11 may be adjusted according to an actual requirement, so as to satisfy effectiveness of contact between the finger and the touch control region 11.

An embedding opening 71 is arranged on the side shield 7, so that the insulating cover plate 1 can be embedded in the embedding opening 71 of the side shield 7 in a matched manner, and the insulating cover plate 1 and the side shield 7 may be combined into a plastic member. The base 3 may be assembled on the side shield 7 by screws, so that the appearance is beautiful, assembling is convenient, and the space required for assembling is reduced.

Preferably, the insulating cover plate 1 may be made of a non-conductive material, such as glass, plastic, and bakelite.

Preferably, the insulating cover plate 1 may also be used instead of the side shield. When the insulating cover plate 1 is directly mounted to the automobile seat as a non-hollowed-out side shield, the touch sensor 2, the base 3, the feedback module 4, the circuit board 5, and the module assembly cover plate 6 are mounted to the non-hollowed-out side shield, that is, a back side of the insulating cover plate 1, so as to further realize the light weight and a simplified design of the automobile seat.

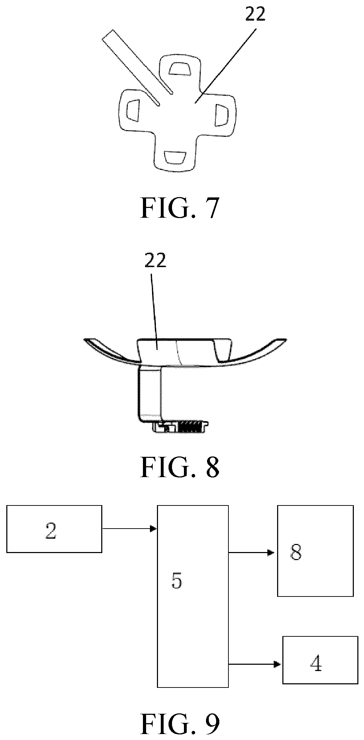

Referring to FIG. 9, the operating principle of the present invention is as follows. A user touches the touch control region 11 by a finger. The touch sensor 2 on the touch control region 11 and the finger form a parallel plate capacitor. The touch sensor 2 transmits the touch signal source to the circuit board 5, and the circuit board 5 converts the touch signal source, and outputs the power to the feedback module 4. The feedback module 4 and the circuit board 5 realize touch feedback, which indicates that the finger identifies the touch control region 11 and causes the circuit board 5 to operate. The circuit board 5 outputs the bus signal to the main control module 8 of the automobile seat, so that the main control module 8 realizes the seat adjustment function corresponding to the touch control region 11. When the finger remains in contact with the touch sensor 2, the seat always performs a corresponding adjustment operation. When the finger is separated from the touch sensor 2, the seat immediately stops the corresponding adjustment operation.

Referring to FIG. 12, a parasitic capacitance CP represents a capacitance between a pin of the touch sensor 2 and the ground, and a finger capacitance CF represents a capacitance between a human body and the ground. Both the capacitances have a same nature.

When the finger does not contact the touch sensor 2, a total sensor capacitance CX is equal to the parasitic capacitance CP. When the finger contacts the touch sensor 2, the total sensor capacitance CX is equal to the parasitic capacitance CP plus the finger capacitance CF.

A capacitance value of the finger capacitance CF may be calculated by Equation (1):

$$CF = \varepsilon 0 * \varepsilon r * A/d \qquad (1)$$

$\varepsilon 0$ is a dielectric constant of air, $\varepsilon r$ is an insulation constant (that is, a relative dielectric constant) of the insulating cover plate 1, A is a contact area between the finger and the insulating cover plate 1 (that is, an area of the touch control region 11), and d is a thickness of the side shield 7.

A shape, a size, and a protruding or recessed structure of the touch control region 11 may be adjusted or customized according to different vehicle models, usage requirements, and the like, with high flexibility and strong manufacturing feasibility.

The foregoing descriptions disclose one embodiment of the present invention, but is not intended to limit the protection scope of the present invention, which is only defined according to the appended claims.

## Claims

1. A 3D touch control-based automobile seat adjustment switch, comprising an insulating cover plate (1), a touch sensor (2), a base (3), a feedback module (4), a circuit board (5), and a module assembly cover plate (6), wherein a plurality of protruding or recessed touch control regions (11) are arranged on the insulating cover plate (1), a plurality of independent touch sensors (2) are attached to the plurality of touch control regions (11) on the insulating cover plate (1), to form a 3D touch assembly, and the plurality of touch sensors (2) are all connected to the circuit board (5);
**characterized in that**,

the circuit board (5) is assembled on the module assembly cover plate (6), the module assembly cover plate (6) and the feedback module (4) are assembled on one surface of the base (3), the feedback module (4) is connected to the circuit board (5), and an other surface of the base (3) is assembled on the insulating cover plate (1), the feedback module (4) is a combination of more than one of a vibration motor (41), a pressure element (42), an electromagnet, or a buzzer; and the feedback module (4) comprises the vibration motor (41) and the pressure element (42), the vibration motor (41) is arranged between the circuit board (5) and the base (3), and the pressure element (42) is a diaphragm pressure sensor and is attached between the circuit board (5) and the module assembly cover plate (6).

2. The 3D touch control-based automobile seat adjustment switch according to claim 1, wherein the touch sensor (2) comprises a flexible substrate and a conductive wire, the conductive wire is printed on the flexible substrate, and the flexible substrate is seamlessly attached to surfaces of the touch control regions (11) by using a double-sided tape.

3. The 3D touch control-based automobile seat adjustment switch according to claim 1, wherein the plurality of touch control regions (11) are not in a same plane, and each touch control region (11) forms an independent branch circuit with the circuit board (5) through the touch sensor (2) on the touch control region (11).

4. The 3D touch control-based automobile seat adjustment switch according to claim 1, wherein an area of the touch control region (11) is not less than 5*5 mm.

5. The 3D touch control-based automobile seat adjustment switch according to claim 1, wherein an embedding opening (71) is arranged on a side shield (7) of an automobile seat, so that the insulating cover plate (1) is embedded in the embedding opening (71) of the side shield (7) in a matched manner, and the base (3) is assembled on the side shield (7).

6. The 3D touch control-based automobile seat adjustment switch according to claim 1, wherein the insulating cover plate (1) is configured as a side shield (7) of an automobile seat.

**Patentansprüche**

1. 3D-touchsteuerungsbasierter Autositzverstellschalter, umfassend eine isolierende Abdeckplatte (1), einen Touchsensor (2), eine Basis (3), ein Feedback-Modul (4), eine Leiterplatte (5) und eine Modulbaugruppenabdeckplatte (6), wobei auf der isolierenden Abdeckplatte (1) mehrere hervorstehende oder vertiefte Touchsteuerungsbereiche (11) angeordnet sind, wobei mehrere unabhängige Touchsensoren (2) an den mehreren Touchsteuerungsbereichen (11) auf der isolierenden Abdeckplatte (1) angebracht sind, um eine 3D-Touchbaugruppe zu bilden, und wobei die mehreren Touchsensoren (2) alle mit der Leiterplatte (5) verbunden sind;
**dadurch gekennzeichnet, dass**

die Leiterplatte (5) auf der Modulbaugruppenabdeckplatte (6) montiert ist, wobei die Modulbaugruppenabdeckplatte (6) und das Feedback-Modul (4) auf einer Oberfläche der Basis (3) montiert sind, wobei das Feedback-Modul (4) mit der Leiterplatte (5) verbunden ist, und wobei eine andere Oberfläche der Basis (3) auf der isolierenden Abdeckplatte (1) montiert ist,
das Feedback-Modul (4) eine Kombination von mehr als einem der Bauteile Vibrationsmotor (41), Druckelement (42), Elektromagnet oder Summer ist; und
das Feedback-Modul (4) den Vibrationsmotor (41) und das Druckelement (42) umfasst, wobei der Vibrationsmotor (41) zwischen der Leiterplatte (5) und der Basis (3) angeordnet ist und das Druckelement (42) ein Membrandrucksensor ist und zwischen der Leiterplatte (5) und der Modulbaugruppenabdeckplatte (6) angebracht ist.

2. 3D-touchsteuerungsbasierter Autositzverstellschalter nach Anspruch 1, **dadurch gekennzeichnet, dass** der Touchsensor (2) ein flexibles Substrat und einen Leitungsdraht umfasst, wobei der Leitungsdraht auf das flexible Substrat gedruckt ist und das flexible Substrat mittels eines doppelseitigen Klebebands nahtlos an den Oberflächen der Touchsteuerungsbereiche (11) angebracht ist.

3. 3D-touchsteuerungsbasierter Autositzverstellschalter nach Anspruch 1, **dadurch gekennzeichnet, dass** die mehreren Touchsteuerungsbereiche (11) nicht in derselben Ebene liegen und jeder Touchsteuerungsbereich (11) über den darauf befindlichen Touchsensor (2) einen unabhängigen Zweigstromkreis mit der Leiterplatte (5) bildet.

4. 3D-touchsteuerungsbasierter Autositzverstellschalter nach Anspruch 1, **dadurch gekennzeichnet, dass** eine Fläche des Touchsteuerungsbereichs (11) mindestens 5×5 mm beträgt.

5. 3D-touchsteuerungsbasierter Autositzverstellschalter nach Anspruch 1, **dadurch gekennzeichnet, dass** in einer Seitenabschirmung (7) eines Autositzes eine Einlassöffnung (71) vorgesehen ist, sodass die isolierende Abdeckplatte (1) passgenau in die Einlassöffnung (71) der Seitenabschirmung (7) eingelassen ist und die Basis (3) an der Seitenabschirmung (7) montiert ist.

6. 3D-touchsteuerungsbasierter Autositzverstellschalter nach Anspruch 1, **dadurch gekennzeichnet, dass** die isolierende Abdeckplatte (1) als Seitenabschirmung (7) eines Autositzes ausgestaltet ist.

**Revendications**

1. Commutateur de réglage de siège d'automobile basé sur une commande tactile 3D, comprenant une plaque de recouvrement isolante (1), un capteur tactile (2), une base (3), un module de rétroaction (4), une carte de circuit imprimé (5) et une plaque de recouvrement d'ensemble de module (6), dans lequel une pluralité de régions de commande tactile (11) saillantes ou encastrées sont disposées sur la plaque de recouvrement isolante (1), une pluralité de capteurs tactiles (2) indépendants sont attachés à la pluralité de régions de commande tactile (11) sur la plaque de recouvrement isolante (1), afin de former un ensemble tactile 3D, et la pluralité de capteurs tactiles (2) sont tous connectés à la carte de circuit imprimé (5) ;
   **caractérisé en ce que**,

   la carte de circuit imprimé (5) est assemblée sur la plaque de recouvrement d'ensemble de module (6), la plaque de recouvrement d'ensemble de module (6) et le module de rétroaction (4) sont assemblés sur une surface de la base (3), le module de rétroaction (4) est connecté à la carte de circuit imprimé (5) et une autre surface de la base (3) est assemblée sur la plaque de recouvrement isolante (1),
   le module de rétroaction (4) est une combinaison de plus d'un parmi un moteur de vibration (41), un élément de pression (42), un électroaimant ou un buzzer ; et
   le module de rétroaction (4) comprend le moteur de vibration (41) et l'élément de pression (42), le moteur de vibration (41) est disposé entre la carte de circuit imprimé (5) et la base (3), et l'élément de pression (42) est un capteur de pression à diaphragme et est attaché entre la carte de circuit imprimé (5) et la plaque de recouvrement d'ensemble de module (6).

2. Commutateur de réglage de siège d'automobile basé sur une commande tactile 3D selon la revendication 1, dans lequel le capteur tactile (2) comprend un substrat flexible et un fil conducteur, le fil conducteur est imprimé sur le substrat flexible, et le substrat flexible est attachée de manière sans joints à surfaces des régions de commande tactile (11) à l'aide d'un ruban adhésif double face.

3. Commutateur de réglage de siège d'automobile basé sur une commande tactile 3D selon la revendication 1, dans lequel la pluralité de régions de commande tactile (11) ne se trouvent pas dans le même plan, et chaque région de commande tactile (11) forme un circuit de dérivation indépendant avec la carte de circuit imprimé (5) par l'intermédiaire du capteur tactile (2) dans la région de commande tactile (11).

4. Commutateur de réglage de siège d'automobile basé sur une commande tactile 3D selon la revendication 1, dans lequel une surface de la région de commande tactile (11) n'est pas inférieure à 5*5 mm.

5. Commutateur de réglage de siège d'automobile basé sur une commande tactile 3D selon la revendication 1, dans lequel une ouverture d'encastrement (71) est disposée sur un bouclier latéral (7) d'un siège d'automobile, de sorte que la plaque de recouvrement isolante (1) est encastrée dans l'ouverture d'encastrement (71) du bouclier latéral (7) de manière adaptée, et la base (3) est assemblée sur le bouclier latéral (7).

6. Commutateur de réglage de siège d'automobile basé sur une commande tactile 3D selon la revendication 1, dans lequel la plaque de recouvrement isolante (1) est configurée comme bouclier latéral (7) d'un siège d'automobile.

FIG. 1

FIG. 2

FIG. 3

FIG. 4

FIG. 5

FIG. 6

FIG. 7

FIG. 8

FIG. 9

FIG. 10

FIG. 11

FIG. 12

**EP 4 105 071 B1**

**Patent documents cited in the description**

- WO 2013058708 A1
- CN 101102917 A
- CN 109039318 A